# FASCICULE DE BREVET EUROPEEN

(11) **EP 3 245 261 B1**
(45) Date de publication et mention de la délivrance du brevet: **31.08.2022**
(21) Numéro de dépôt: 16703569.0
(22) Date de dépôt: 11.01.2016
(51) Int. Cl.: C09D 127/16, C08L 27/16, H01L 41/193, C08L 67/02

(54) **COMPOSITION A BASE DE TERPOLYMÈRE ÉLECTROACTIF**
ZUSAMMENSETZUNG AUS EINEM ELEKTROAKTIVEN TERPOLYMEREN
COMPOSITION COMPRISING AN ELECTROACTIVE TERPOLYMER

(30) Priorité: 14.01.2015 FR 1550291
(43) Date de publication de la demande: 22.11.2017
(73) Titulaire: Arkema France, 92700 Colombes (FR); Institut National des Sciences Appliquées de Lyon, 69621 Villeurbanne Cedex (FR)
(72) Inventeur: DOMINGUES DOS SANTOS, Fabrice, 75003 Paris (FR); LANNUZEL, Thierry, 69100 Villeurbanne (FR); CAPSAL, Jean-Fabien, 69350 La Mulatiere (FR); COTTINET, Pierre-Jean, 69480 Pommiers (FR); GALINEAU, Jérémy, 38510 Morestel (FR); LE, Minh-Quyen, 69480 Pommiers (FR)
(74) Mandataire: Arkema Patent
(86) Numéro de dépôt international: PCT/FR2016/050042
(87) Numéro de publication internationale: WO 2016/113492

(56) Documents cités:
- WO-A1-2011/008940
- US-A- 3 541 039
- US-A1- 2012 248 945
- JEAN-FABIEN CAPSAL ET AL: "Plasticized relaxor ferroelectric terpolymer: Toward giant electrostriction, high mechanical energy and low electric field actuators", SENSORS AND ACTUATORS A: PHYSICAL, vol. 207, 19 décembre 2013 (2013-12-19), pages 25-31, XP055213712, ISSN: 0924-4247, DOI: 10.1016/j.sna.2013.12.008
- KIM K J ET AL: "Miscibility, phase behavior, and Curie transition in blends of vinylidene fluoride/trifluoroethylene copolymer and Poly(1,4-butylene adipate)", POLYMER, ELSEVIER SCIENCE PUBLISHERS B.V, GB, vol. 40, no. 22, 1 octobre 1999 (1999-10-01), pages 6125-6134, XP004172482, ISSN: 0032-3861, DOI: 10.1016/S0032-3861(98)00825-8

## Description

### DOMAINE DE L'INVENTION

La présente invention concerne une composition obtenue par mélange d'un terpolymère fluoré électroactif et d'un polymère compatible avec le terpolymère fluoré électroactif et présentant une température de transition vitreuse inférieure à celle du terpolymère fluoré électroactif. L'invention concerne également le procédé de fabrication de cette composition.

### ARRIERE-PLAN TECHNIQUE

Les polymères fluorés représentent une classe de composés ayant des propriétés remarquables pour un grand nombre d'applications, depuis la peinture ou les revêtements spéciaux jusqu'aux joints d'étanchéité, en passant par l'optique, la microélectronique et la technologie membranaire. Parmi ces polymères fluorés, les copolymères sont particulièrement intéressants en raison de leur diversité, de leur morphologie, de leurs propriétés exceptionnelles et de leur versatilité.

Les terpolymères fluorés électroactifs, généralement utilisés sous forme de films, de dépôts ou d'empilements, combinés à des électrodes, ont des propriétés électromécaniques remarquables. Ils possèdent une forte densité d'énergie électromécanique. Ainsi, lorsque des dispositifs comprenant de tels terpolymères sont soumis à un champ électrique, ils se déforment, ce qui permet la réalisation d'actionneurs.

Le document US 6,787,238 décrit la préparation de terpolymères selon une méthode de polymérisation d'un mélange de trois monomères comprenant un monomère de fluorure de vinylidène (VDF), un monomère tel que le tétrafluoroéthylène (TFE) ou le trifluoroéthylène (TrFE) et un monomère tel que le tétrafluoroéthylène (TFE), le fluorure de vinyle, le perfluoro(éther vinylique de méthyle), le bromotrifluoroéthylène, le chlorofluoroéthylène, le chlorotrifluoroéthylène (CTFE) et l'hexafluoropropylène (HFP).

Le document US 6,355,479 décrit la préparation de terpolymères de fluorure de vinylidène, de trifluoroéthylène et d'un comonomère tel que le CTFE ou l'HFP, selon un procédé de copolymérisation contrôlée au moyen de composés boranes en présence d'oxygène.

Le document US 5,087,679 décrit la préparation d'un terpolymère diélectrique qui comprend du fluorure de vinylidène, du trifluoroéthylène et du chlorotrifluoroéthylène.

Le document US 4,554,335 décrit un matériau polymère diélectrique composé de fluorure de vinylidène, de trifluorure d'éthylène, de chlorure de trifluorure d'éthylène, et d'un autre monomère contenant du fluor.

L'article High Electromechanical Responses in a Poly(vinylidene fluoride-trifluoroethylenechlorofluoroethylene) Terpolymer de Xia et al. publié dans Advanced Materials, 14:1574-1577 (2002) montre l'importance d'un troisième monomère pour influencer la microstructure du copolymère de fluorure de vinylidène et de trifluoroéthylène.

L'article Influencing dielectric properties of relaxor polymer system by blending vinylidene fluoride-trifluoroethylene-based terpolymer with a ferroelectric copolymer de Casar et al. dans Journal of Applied Physics 115:104101 (2014) décrit le mélange d'un terpolymère relaxeur P(VDF-TrFE-CFE) et d'un polymère ferroélectrique P(VDF-TrFE).

De même, l'article A polymer blend approach to tailor the ferroelectric reponses in P(VDF-TrFE) based copolymers, de Chen et al. dans Polymer 54:2373-2381 (2013) décrit également le mélange d'un terpolymère et d'un copolymère. L'article "Plasticized relaxor ferroelectric terpolymer: Toward giant electrostriction, high mechanical energy and low electric field actuators", de J.-F. Capsal et al. publié dans Sensors and Actuators A: Physical 207: 25-31 (2013) décrit un mélange de terpolymère P(VDF-TrFE-CFE) plastifié avec du diéthylhexyl phtalate et des actionneurs faits avec ce mélange.

Le document WO 2011/008940 décrit le mélange d'un terpolymère et d'un autre polymère fluoré. Le document EP 0206926 décrit des mélanges de polymères ou copolymères fluorés.

Enfin, le document WO 2014/170479 décrit des mélanges d'un terpolymère P(VDF-TrFE-CFE) ou P(VDF-TrFE-CTFE) avec un plastifiant de type phtalate, et leur utilisation pour fabriquer des films et des actionneurs. Il est exposé que ces mélanges présentent une permittivité diélectrique améliorée.

Ces mélanges présentent toutefois un mauvais profil écotoxicologique, le plastifiant phtalate utilisé étant toxique. Par ailleurs, les présents inventeurs ont constaté que le plastifiant phtalate présente une tendance au relargage (ou suintement), ce qui représente un risque pour la santé, rend difficile le dépôt d'électrodes et peut entraîner une diminution importante des propriétés mécaniques des films obtenus.

Il existe donc un besoin de mettre au point une composition présentant de bonnes propriétés électromécaniques (notamment pour une utilisation dans des actionneurs), ayant un profil éco-toxicologique satisfaisant et ne présentant pas de risque de relargage.

### RESUME DE L'INVENTION

L'invention concerne en premier lieu une composition comprenant :
- au moins un terpolymère fluoré électroactif, le terpolymère fluoré électroactif étant un terpolymère de fluorure de vinylidène, de trifluoroéthylène et d'un tiers monomère, la proportion molaire en tiers monomère valant de 2 à 15%, le tiers monomère étant le chlorofluoro-1,1-éthylène ou le chlorotrifluoroéthylène et

- au moins un deuxième polymère, étant un polyester, compatible avec le terpolymère fluoré électroactif, et présentant une température de transition vitreuse inférieure à celle du terpolymère fluoré électroactif,
la température de transition vitreuse étant mesurée par calorimétrie différentielle à balayage selon la norme ASTM E1356 ;
le mot « compatible » signifiant que le mélange dudit au moins un terpolymère fluoré électroactif avec ledit au moins un deuxième polymère forme une phase homogène avec une température de transition vitreuse unique.

Selon un mode de réalisation, le deuxième polymère présente une température de transition vitreuse inférieure d'au moins 5°C, de préférence d'au moins 10°C, ou d'au moins 15°C, ou d'au moins 20°C, à celle du terpolymère fluoré électroactif.

Selon un mode de réalisation, la température de transition vitreuse du terpolymère fluoré électroactif vaut de -50°C à +10°C, de préférence de -40°C à -10°C ; et/ou la température de transition vitreuse du deuxième polymère vaut de -100°C à -0°C, de préférence de -100°C à -40°C.

Le terpolymère fluoré électroactif est un terpolymère de fluorure de vinylidène, de trifluoroéthylène et d'un tiers monomère.

Le tiers monomère est le chlorofluoro-1,1-éthylène ou le chlorotrifluoroéthylène.

Le deuxième polymère est un polyester. De préférence le deuxième polymère est choisi parmi les polyadipates, les polyglutarates et les polysébaçates.

Selon un mode de réalisation, le terpolymère fluoré électroactif et le deuxième polymère sont présents dans un rapport massique de 50:50 à 99:1, de préférence de 70:30 à 95:5, de manière plus particulièrement préférée de 80:20 à 90:10.

Selon un mode de réalisation, la composition comprend au moins un solvant, de préférence choisi parmi le tétrahydrofurane, la méthyl éthyl cétone, le diméthylformamide, le diméthylacetamide, la tétraméthylurée, le diméthylsulfoxide, le triméthylphosphate, la N-méthyl-2-pyrrolidone, l'acétone, la méthyl isobutyl cétone, les éthers de glycol, les glycol éther esters, le N-butyl acétate, la cyclohexanone, l'alcool diacétone, la diisobutylcétone, l'éthyl acéto acétate, le butyrolactone, l'isophorone, le triéthylphosphate, le carbitol acétate, le carbonate de propylène et le glycéryl triacétate.

Selon un mode de réalisation :
- le terpolymère fluoré électroactif présente un poids moléculaire de 200 000 à 1 500 000, de préférence de 250 000 à 1 000 000, plus particulièrement de 300 000 à 700 000 ; et/ou
- le deuxième polymère présente un poids moléculaire de 500 à 700 000, de préférence de 2 000 à 100 000, et plus particulièrement de 5 000 à 20 000.

Selon un mode de réalisation, la composition comprend également un copolymère fluoré, notamment ferroélectrique, de préférence choisi parmi les copolymères de fluorure de vinylidène et de trifluoroéthylène, de fluorure de vinylidène et de chlorotrifluoroéthylène, de fluorure de vinylidène et de tétra fluoroéthylène, et de fluorure de vinylidène et d'hexafluoropropylène.

L'invention concerne également un procédé de fabrication d'une composition telle que décrite ci-dessus, comprenant une étape de mélange du terpolymère fluoré électroactif avec le deuxième polymère.

Selon un mode de réalisation, le mélange est effectué dans un solvant, de préférence choisi parmi le tétrahydrofurane, la méthyl éthyl cétone, le diméthylformamide, le diméthylacetamide, la tétraméthylurée, le diméthylsulfoxide, le triméthylphosphate, la N-méthyl-2-pyrrolidone, l'acétone, la méthyl isobutyl cétone, les éthers de glycol, les glycol éther esters, le N-butyl acétate, la cyclohexanone, l'alcool diacétone, la diisobutylcétone, l'éthyl acéto acétate, le butyrolactone, l'isophorone, le triéthylphosphate, le carbitol acétate, le carbonate de propylène et le glycéryl triacétate ; de préférence en dissolvant le terpolymère fluoré électroactif puis le deuxième polymère dans le solvant.

L'invention concerne également un dispositif comprenant un substrat, et un film de la composition décrite ci-dessus disposé sur celui-ci.

Selon un mode de réalisation, le dispositif comprend en outre des électrodes de part et d'autre du film, ledit dispositif étant de préférence un actionneur.

L'invention concerne également un procédé de fabrication du dispositif ci-dessus, comprenant une étape de dépôt du film sur le substrat.

Selon un mode de réalisation, l'étape du dépôt est une étape d'enduction ou d'impression de la composition sur le substrat.

Selon un mode de réalisation, le procédé de fabrication comprend une étape supplémentaire de dépôt d'électrodes, de préférence par évaporation ou pulvérisation de métal, d'oxyde indium-étain, d'une couche de polymère conducteur, d'encre conductrice à base d'argent, de nanofils d'argent, ou de graphène.

La présente invention permet de surmonter les inconvénients de l'état de la technique. Elle fournit plus particulièrement une composition présentant de bonnes propriétés électromécaniques (notamment pour une utilisation dans des actionneurs), ayant un profil éco-toxicologique satisfaisant et ne présentant pas de risque de relargage.

Cela est accompli grâce à l'association entre un terpolymère fluoré électroactif et un deuxième polymère compatible avec le terpolymère, présentant une température de transition vitreuse inférieure à celle du terpolymère.

Les présents inventeurs ont découvert que cette association permet d'obtenir des propriétés électromécaniques considérablement améliorées (déformation plus élevée sous champ électrique, propriétés électromécaniques étendues sur une large gamme de température) par rapport à celles du terpolymère seul, tout en évitant les problèmes de toxicité ou de relargage rencontrés lorsque des plastifiants de type phtalates sont utilisés. Les propriétés mécaniques (notamment le module d'élasticité) ne sont pas non plus altérées, par rapport aux terpolymères seuls.

En particulier, la composition de l'invention offre une facilité de mise en œuvre, en particulier lors de la fabrication de films ou de dépôts multicouches, du fait de l'absence de relargage de composé.

Elle est particulièrement appropriée pour la fabrication d'actionneurs.

### DESCRIPTION DE MODES DE REALISATION DE L'INVENTION

L'invention est maintenant décrite plus en détail et de façon non limitative dans la description qui suit.

L'invention repose d'abord sur l'utilisation d'un terpolymère fluoré électroactif. Par « *fluoré* » on entend un terpolymère comportant des groupements -F. Par « *électroactif »,* on entend un terpolymère susceptible de se déformer sous l'effet d'un champ électrique.

De préférence, le terpolymère fluoré est un polymère ferroélectrique relaxeur. Un tel matériau présente un champ coercitif faible (typiquement inférieur à 10 V/µm) et une polarisation rémanente faible (typiquement inférieure à 10 mC/m²) voire nulle.

Le terpolymère comporte des motifs de fluorure de vinylidène.

Le terpolymère est de formule P(VDF-TrFE-X), où VDF représente des motifs de fluorure de vinylidène, TrFE représente des motifs de trifluoroéthylène, et X représente des motifs issus d'un tiers monomère. X représente des motifs issus du CFE (1-chloro-1-fluoroéthylène) ou du CTFE (chlorotrifluoroéthylène).

Les terpolymères de l'invention peuvent être produits en utilisant tout procédé connu, tel que la polymérisation en émulsion, la polymérisation en suspension et la polymérisation en solution. L'utilisation du procédé décrit dans le document WO 2010/116105 est particulièrement préférée. Ce procédé permet d'obtenir des polymères de poids moléculaire élevé et de structuration adaptée.

La proportion molaire de motifs X dans le terpolymère vaut de 2 à 15 %. De préférence, la proportion molaire de motifs X dans le terpolymère vaut de 3 à 12 %, et de manière plus particulièrement préférée de 5 à 10 %.

Selon un mode de réalisation, le rapport molaire des motifs VDF sur les motifs TrFE dans le terpolymère vaut de 80/20 à 50/50, et de préférence de 72/28 à 60/40.

Selon un mode de réalisation, la masse molaire moyenne en poids, qui dans le cadre de cette demande est également désignée par «poids moléculaire» (Mw), du terpolymère, vaut de 200 000 à 1 500 000, de préférence de 250 000 à 1 000 000, et plus particulièrement de 300 000 à 700 000.

Cette dernière peut être ajustée par modification de certains paramètres du procédé, tels que la température dans le réacteur, ou par ajout d'un agent de transfert.

La distribution de poids moléculaire peut être estimée par SEC (chromatographie d'exclusion stérique) avec du diméthylformamide (DMF) en tant qu'éluant, avec un ensemble de 3 colonnes de porosité croissante. La phase stationnaire est un gel de styrène-DVB. Le procédé de détection est fondé sur une mesure de l'indice de réfraction, et l'étalonnage est réalisé avec des étalons de polystyrène. L'échantillon est mis en solution à 0,5 g/L dans du DMF et filtré sur un filtre en nylon de 0,45 µm.

Le poids moléculaire peut également être évalué par mesure de l'indice de fluidité à 230°C sous une charge de 5 kg selon ASTM D1238 (ISO 1133).

Par ailleurs, le poids moléculaire peut également être caractérisé par une mesure de la viscosité en solution selon la norme ISO 1628. La méthyléthylcétone (MEK) est un solvant préféré des terpolymères pour la détermination de l'indice de viscosité.

Plus généralement, la composition molaire des terpolymères de l'invention peut être déterminée par divers moyens. Les méthodes classiques d'analyse élémentaire en éléments carbone, fluor et chlore ou brome conduisent à un système de deux ou trois équations indépendantes à deux inconnues indépendantes (par exemple % VDF et % TrFE, avec % X = 100 - (% VDF + % TrFE)), qui permet de calculer sans ambiguïté la composition massique des polymères, d'où l'on déduit la composition molaire.

On peut également mettre en œuvre les techniques de RMN multi-noyaux, ici proton (¹H) et fluor (¹⁹F), par analyse d'une solution du polymère dans un solvant deutéré approprié. Le spectre RMN est enregistré sur un spectromètre RMN-FT équipé d'une sonde multi-nucléaire. On repère alors les signaux spécifiques donnés par les différents monomères dans les spectres réalisés selon l'un ou l'autre noyaux. Ainsi, par exemple, l'unité TrFE (CFH=CF₂) donne en RMN du proton un signal spécifique caractéristique du groupement CFH (à environ 5 ppm). Il en est de même pour les groupements CH₂ du VDF (massif centré à 3 ppm). L'intégration relative des deux signaux donne l'abondance relative des deux monomères, c'est-à-dire le rapport molaire VDF / TrFE.

La combinaison des intégrations relatives des différents signaux obtenus en RMN du proton et en RMN du fluor conduit à un système d'équations dont la résolution conduit à l'obtention des concentrations molaires des différentes unités monomériques.

Il est enfin possible de combiner l'analyse élémentaire, par exemple pour les hétéroatomes comme le chlore ou le brome, et l'analyse RMN. C'est ainsi que la teneur en CTFE ou en CFE peut être déterminée par une mesure de la teneur en chlore par analyse élémentaire.

L'homme du métier dispose ainsi d'une palette de méthodes ou de combinaison de méthodes lui permettant de déterminer sans ambiguïté et avec la précision nécessaire la composition des terpolymères de l'invention.

L'invention repose ensuite sur l'utilisation d'un deuxième polymère, compatible avec le terpolymère et présentant une température de transition vitreuse inférieure à celle du terpolymère.

Par « *compatible* » on entend que le mélange des deux polymères forme une phase homogène avec une température de transition vitreuse unique.

La température de transition vitreuse des polymères de l'invention peut être mesurée par calorimétrie différentielle à balayage, par exemple selon la norme ASTM E1356.

Ainsi, de préférence la température de transition vitreuse du deuxième polymère est inférieure d'au moins 5°C, ou d'au moins 10°C, ou d'au moins 15°C, ou d'au moins 20°C, à la température de transition vitreuse du terpolymère.

Selon un mode de réalisation, la température de transition vitreuse du terpolymère peut valoir de 10 à -50°C, de préférence de 0 à -40 °C et plus particulièrement de -10 à -40°C (par exemple environ -20°C).

Selon un mode de réalisation, la température de transition vitreuse du deuxième polymère peut être inférieure à -20°C, de préférence inférieure à -30°C et plus particulièrement inférieure à -40 °C. Par exemple, elle peut valoir de -100°C à -0°C, de préférence de -100°C à -40°C.

De manière préférée, le deuxième polymère comporte une température de transition vitreuse unique.

De manière préférée, le deuxième polymère n'est pas un copolymère à blocs ni un copolymère à greffons.

De manière préférée, il s'agit soit d'un homopolymère, soit d'un copolymère à structure homogène, dans lequel les unités monomères sont réparties de manière périodique, aléatoire ou statistique.

De manière préférée, le deuxième polymère n'est pas fluoré.

De manière préférée, le deuxième polymère n'est pas un polymère ferroélectrique.

De manière préférée, le deuxième polymère n'est pas un polymère électroactif.

De manière préférée, le deuxième polymère est un polymère polaire.

De manière préférée, le deuxième polymère est un polymère noncristallin. On peut considérer que les polymères pour lesquels une mesure de calorimétrie différentielle à balayage révèle un phénomène endothermique assimilable à une fusion d'enthalpie inférieur à 5 J/g sont des polymères noncristallins.

Le deuxième polymère est un polyester. De préférence il s'agit d'un polyadipate, d'un polyglutarate ou d'un polysébaçate.

Le poids moléculaire du deuxième polymère est de préférence supérieur ou égal à 500, ou à 2000 ou à 5000. Il est de préférence inférieur ou égal à 700000, et plus particulièrement inférieur ou égal à 20000.

La composition de l'invention comprend au moins un terpolymère tel que décrit ci-dessus (éventuellement deux ou plusieurs de ceux-ci), et au moins un deuxième polymère tel que décrit ci-dessus (éventuellement deux ou plusieurs de ceux-ci).

Cette composition peut également comporter un solvant (auquel cas il peut s'agir d'une composition adaptée à être déposée sur un substrat par exemple). Alternativement, elle peut être dépourvue de solvant (une telle composition pouvant par exemple être obtenue à partir de la précédente par évaporation du solvant, par exemple après dépôt sur un substrat).

A titre de solvant approprié, on peut notamment utiliser le tétrahydrofurane, la méthyl éthyl cétone, le diméthylformamide, le diméthylacetamide, la tétraméthylurée, le diméthylsulfoxide, le triméthylphosphate, la N-méthyl-2-pyrrolidone, l'acétone, la méthyl isobutyl cétone, les éthers de glycol, les glycol éther esters, le N-butyl acétate, la cyclohexanone, l'alcool diacétone, la diisobutylcétone, l'éthyl acéto acétate, le butyrolactone, l'isophorone, le triéthylphosphate, le carbitol acétate, le carbonate de propylène et le glycéryl triacétate.

La composition de l'invention peut également comprendre un ou plusieurs polymères supplémentaires, tels que des copolymères fluorés ferroéléctriques (par exemple le P(VDF-TrFE)) ou non (par exemple P(VDF-CTFE), P(VDF-HFP)).

La composition de l'invention peut également comprendre un ou plusieurs additifs, notamment choisis parmi les plastifiants, les sels et les ignifugeants.

De manière préférée, la composition selon l'invention est dépourvue de composé de type phtalate.

Le terpolymère fluoré électroactif et le deuxième polymère sont avantageusement présents dans un rapport massique terpolymère : deuxième polymère de 50:50 à 99:1, de préférence de 70:30 à 95:5, de manière plus particulièrement préférée de 80:20 à 90:10.

Lorsque la composition comprend un solvant, celui-ci peut être de préférence présent dans une proportion massique d'au moins 50 %, de préférence d'au moins 80 %, de manière plus particulièrement préférée d'au moins 95 %, voire d'au moins 99 %.

La composition de l'invention peut être fabriquée en dissolvant ses différents composés dans un solvant (notamment tel que décrit ci-dessus). Il est préféré de dissoudre le terpolymère dans le solvant avant le deuxième polymère. Eventuellement, le solvant peut ensuite être évaporé.

Alternativement, la composition peut être fabriquée en voie fondue, en l'absence de solvant.

L'invention fournit notamment des films fabriqués à partir de compositions selon l'invention et déposés sur un substrat. Le substrat peut, par exemple, être un substrat polymérique, tel qu'un substrat de poly(téréphtalate d'éthylène) ou de polyéthylène naphthalate, ou bien encore un substrat du papier, du verre ou du silicium.

De préférence, le film est déposé en voie solvant ou fondue ; puis séché et recuit pour le cristalliser (par chauffage à une température inférieure à la température de fusion de la composition, pendant une durée supérieure ou égale à 1 minute).

L'invention fournit également des structures multicouches, comportant au moins un film de composition de l'invention et des électrodes de part et d'autre.

De telles structures peuvent notamment être réalisées :
- par enduction de la composition sur un substrat, évaporation du solvant, recuit et dépôt d'électrodes par évaporation ou pulvérisation de dépôt métallique, d'oxyde indium-étain (ITO), dépôt d'une couche de polymère conducteur, dépôt d'une couche conductrice à partir d'encres conductrices à base d'argent, de nanofils d'argent, ou de graphène... ; ou bien
- par impression de la composition sur un substrat, par exemple par sérigraphie, héliogravure, offset..., puis recuit et dépôt d'électrodes par évaporation ou pulvérisation de dépôt métallique, d'oxyde indium-étain (ITO), dépôt d'une couche de polymère conducteur, dépôt d'une couche conductrice à partir d'encres conductrices à base d'argent, de nano-fils d'argent...

Ces structures multicouches peuvent ainsi fournir des actionneurs.

D'autres objets pouvant être réalisés grâce aux compositions de l'invention comprennent des fibres, des filaments, des câbles et des fibres muticomposants, incluant une âme centrale conductrice réalisés par voie solvant ou par extrusion.

### EXEMPLES

Les exemples suivants illustrent l'invention sans la limiter.

Afin de caractériser les propriétés électromécaniques des polymères, 15% en poids de polymère(s) électroactif(s) sont dissouts dans de la méthyl-éthyl-cétone, dans un ballon chauffant surmonté d'une colonne réfrigérée. Le mélange est effectué sous reflux à 80°C, sous agitation magnétique. Après dissolution complète, la solution est filtrée à 1 µm. La solution est ensuite déposée sous atmosphère contrôlé, par enduction, sur une plaque de verre. Le solvant est laissé à évaporer pendant 12 heures. Les films obtenus sont ensuite portés à 80°C dans un four pour éliminer les traces de solvant. Les films sont ensuite recuits à 115°C pendant 1 heure.

Des films sont ensuite placés à température ambiante, le relargage de composés volatils est examiné visuellement et par toucher après 12 heures.

Des films sont recouverts d'électrodes par évaporation sous vide d'or. Leurs propriétés diélectriques sont mesurées par spectroscopie d'impédance. Leurs propriétés mécaniques sont mesurées par analyse mécanique dynamique.

Afin de mesurer les propriétés électromécaniques, les films électrodés sont fixés sur des substrats flexibles de polytéréphtalate d'éthylène de 100 µm grâce à un adhésif (Scotch 3M ATG 924). Les multicouches ainsi réalisés sont ensuite laminés pendant 15 minutes grâce à une lamineuse D&K 4468H. Les films sont ensuite fixés sur des supports. Chaque face de film est reliée à un pôle d'un générateur de tension électrique variable (Trek 609D-6).

Lorsque l'échantillon est soumis à une tension électrique, sa déflection est mesurée grâce à un capteur de déformation laser (BAUMER CH8501). La déformation longitudinale du film S₃₁(E) de polymère est calculée à partir des propriétés mécaniques des différentes couches et de la géométrie des échantillons.

Dans l'exemple 1, le polymère utilisé est un terpolymère P(VDF-TrFE-CTFE) de composition molaire 61,0 / 30,1 / 8,9.

L'exemple 2 est semblable à l'exemple 1, à ceci près qu'à la fin de la dissolution du polymère, on ajoute 15 % en poids par rapport au polymère de polymère polaire non cristallin de type polyester (Palamoll 652 / BASF).

Dans l'exemple 3, il est procédé comme pour l'exemple 1, mais à la fin de la dissolution du polymère, on ajoute 15 % en poids par rapport au polymère de plastifiant non polymérique diéthyl-hexyl phtalate.

Ce plastifiant est classifié cancérogène, mutagène et reprotoxique.

| | S31 (10 V/µm) % | Relargage après 12 h | Profil éco-toxicologique |
|---|---|---|---|
| Exemple 1 (comparatif) | 0,0025 | Aucun | Bon |
| Exemple 2 (invention) | 0,2 | Aucun | Bon |
| Exemple 3 (comparatif) | 0,4 | Elevé | Mauvais |

On constate que l'exemple correspondant à l'invention permet d'obtenir des films et des dispositifs sans relargage, à bon profil éco-toxicologique et aux propriétés électromécaniques à faible champ améliorées.

## Revendications

1. Composition comprenant :
- au moins un terpolymère fluoré électroactif, le terpolymère fluoré électroactif étant un terpolymère de fluorure de vinylidène, de trifluoroéthylène et d'un tiers monomère, la proportion molaire en tiers monomère valant de 2 à 15%, le tiers monomère étant le chlorofluoro-1,1-éthylène ou le chlorotrifluoroéthylène et
- au moins un deuxième polymère, étant un polyester, compatible avec le terpolymère fluoré électroactif, et présentant une température de transition vitreuse inférieure à celle du terpolymère fluoré électroactif,
la température de transition vitreuse étant mesurée par calorimétrie différentielle à balayage selon la norme ASTM E1356 ;
le mot « compatible » signifiant que le mélange dudit au moins un terpolymère fluoré électroactif avec ledit au moins un deuxième polymère forme une phase homogène avec une température de transition vitreuse unique.

2. Composition selon la revendication 1, dans laquelle le deuxième polymère présente une température de transition vitreuse inférieure d'au moins 5°C, de préférence d'au moins 10°C, ou d'au moins 15°C, ou d'au moins 20°C, à celle du terpolymère fluoré électroactif.

3. Composition selon l'une quelconque des revendications 1 ou 2, dans laquelle la température de transition vitreuse du terpolymère fluoré électroactif vaut de - 50°C à +10°C, de préférence de -40°C à -10°C ; et/ou la température de transition vitreuse du deuxième polymère vaut de -100°C à -0°C, de préférence de -100°C à -40°C.

4. Composition selon l'une quelconque des revendications 1 à 3, dans laquelle le deuxième polymère est choisi parmi les polyadipates, les polyglutarates et les polysébaçates.

5. Composition selon l'une quelconque des revendications 1 à 4, dans laquelle le terpolymère fluoré électroactif et le deuxième polymère sont présents dans un rapport massique de 50:50 à 99:1, de préférence de 70:30 à 95:5, de manière plus particulièrement préférée de 80:20 à 90:10.

6. Composition selon l'une quelconque des revendications 1 à 5, comprenant au moins un solvant, de préférence choisi parmi le tétrahydrofurane, la méthyl éthyl cétone, le diméthylformamide, le diméthylacetamide, la tétraméthylurée, le diméthylsulfoxide, le triméthylphosphate, la N-méthyl-2-pyrrolidone, l'acétone, la méthyl isobutyl cétone, les éthers de glycol, les glycol éther esters, le N-butyl acétate, la cyclohexanone, l'alcool diacétone, la diisobutylcétone, l'éthyl acéto acétate, le butyrolactone, l'isophorone, le triéthylphosphate, le carbitol acétate, le carbonate de propylène et le glycéryl triacétate.

7. Composition selon l'une quelconque des revendications 1 à 6, dans laquelle :
- le terpolymère fluoré électroactif présente un poids moléculaire Mw de 200 000 à 1 500 000, de préférence de 250 000 à 1 000 000, plus particulièrement de 300 000 à 700 000 ; et/ou
- le deuxième polymère présente un poids moléculaire Mw de 500 à 700 000, de préférence de 2 000 à 100 000, et plus particulièrement de 5 000 à 20 000,
le poids moléculaire Mw étant déterminé par chromatographie d'exclusion stérique, la chromatographie étant mise en œuvre avec les paramètres suivants :
- utilisation de 3 colonnes de porosité croissante ;
- l'éluant est du diméthylformamide ;
- la phase stationnaire est un gel de styrène-DVB ;
- la détection est fondé sur une mesure de l'indice de réfraction ; et,
- l'étalonnage est réalisé avec des étalons de polystyrène.

8. Composition selon l'une quelconque des revendications 1 à 7, comprenant également un copolymère fluoré, notamment ferroélectrique, de préférence choisi parmi les copolymères de fluorure de vinylidène et de trifluoroéthylène, de fluorure de vinylidène et de chlorotrifluoroéthylène, de fluorure de vinylidène et de tétra fluoroéthylène, et de fluorure de vinylidène et d'hexafluoropropylène.

9. Composition selon l'une quelconque des revendications 1 à 8, dans laquelle le terpolymère fluoré électroactif est un terpolymère relaxeur.

10. Procédé de fabrication d'une composition selon l'une quelconque des revendications 1 à 9, comprenant une étape de mélange du terpolymère fluoré électroactif avec le deuxième polymère.

11. Procédé de fabrication selon la revendication 10, dans lequel le mélange est effectué dans un solvant, de préférence choisi parmi le tétrahydrofurane, la méthyl éthyl cétone, le diméthylformamide, le diméthylacetamide, la tétraméthylurée, le diméthylsulfoxide, le triméthylphosphate, la N-méthyl-2-pyrrolidone, l'acétone, la méthyl isobutyl cétone, les éthers de glycol, les glycol éther esters, le N-butyl acétate, la cyclohexanone, l'alcool diacétone, la diisobutylcétone, l'éthyl acéto acétate, le butyrolactone, l'isophorone, le triéthylphosphate, le carbitol acétate, le carbonate de propylène et le glycéryl triacétate ; de préférence en dissolvant le terpolymère fluoré électroactif puis le deuxième polymère dans le solvant.

12. Dispositif comprenant un substrat, et un film de la composition selon l'une des revendications 1 à 9 disposé sur celui-ci.

13. Dispositif selon la revendication 12, comprenant en outre des électrodes de part et d'autre du film, ledit dispositif étant de préférence un actionneur.

14. Procédé de fabrication du dispositif selon l'une quelconque des revendications 12 ou 13, comprenant une étape de dépôt du film sur le substrat.

15. Procédé de fabrication du dispositif selon la revendication 14, dans lequel l'étape du dépôt est une étape d'enduction ou d'impression de la composition sur le substrat.

16. Procédé de fabrication du dispositif selon l'une quelconque des revendications 14 ou 15, comprenant une étape supplémentaire de dépôt d'électrodes, de préférence par évaporation ou pulvérisation de métal, d'oxyde indium-étain, d'une couche de polymère conducteur, d'encre conductrice à base d'argent, de nanofils d'argent, ou de graphène.

## Patentansprüche

1. Zusammensetzung, die Folgendes umfasst:
- mindestens ein elektroaktives fluoriertes Terpolymer, wobei das elektroaktive fluorierte Terpolymer ein Terpolymer von Vinylidenfluorid, Trifluorethylen und einem dritten Monomer ist, der Stoffmengenanteil des dritten Monomers 2 bis 15 % beträgt und das dritte Monomer 1-Chlor-1-fluorethylen oder Chlortrifluorethylen ist, und
- mindestens ein zweites Polymer, bei dem es sich um einen mit dem elektroaktiven fluorierten Terpolymer verträglichen Polyester handelt und dessen Glasübergangstemperatur niedriger als diejenige des elektroaktiven fluorierten Terpolymers ist,
wobei die Glasübergangstemperatur mittels Differentialthermoanalyse gemäß der Norm ASTM E1356 gemessen wird;
wobei das Wort "verträglich" bedeutet, dass das Gemisch des mindestens einen elektroaktiven fluorierten Terpolymers mit dem mindestens einen zweiten Polymer eine homogene Phase mit einer einzigen Glasübergangstemperatur bildet.

2. Zusammensetzung nach Anspruch 1, wobei das zweite Polymer eine Glasübergangstemperatur aufweist, die mindestens 5 °C, vorzugsweise mindestens 10 °C oder mindestens 15 °C oder mindestens 20 °C niedriger als diejenige des elektroaktiven fluorierten Terpolymers ist.

3. Zusammensetzung nach einem der Ansprüche 1 oder 2, wobei die Glasübergangstemperatur des elektroaktiven fluorierten Terpolymers einen Wert von -50 °C bis +10 °C, vorzugsweise -40 °C bis -10 °C, aufweist und/oder die Glasübergangstemperatur des zweiten Polymers einen Wert von -100 °C bis -0 °C, vorzugsweise -100 °C bis -40 °C, aufweist.

4. Zusammensetzung nach einem der Ansprüche 1 bis 3, wobei das zweite Polymer aus Polyadipaten, Polyglutaraten und Polysebacaten ausgewählt ist.

5. Zusammensetzung nach einem der Ansprüche 1 bis 4, wobei das elektroaktive fluorierte Terpolymer und das zweite Polymer in einem Gewichtsverhältnis von 50:50 bis 99:1, vorzugsweise 70:30 bis 95:5, besonders bevorzugt 80:20 bis 90:10, vorhanden sind.

6. Zusammensetzung nach einem der Ansprüche 1 bis 5, die mindestens ein Lösungsmittel umfasst, das vorzugsweise aus Tetrahydrofuran, Methylethylketon, Dimethylformamid, Dimethylacetamid, Tetramethylharnstoff, Dimethylsulfoxid, Trimethylphosphat, N-Methyl-2-pyrrolidon, Aceton, Methylisobutylketon, Glycolethern, Glycoletherestern, n-Butylacetat, Cyclohexanon, Diacetonalkohol, Diisobutylketon, Ethylacetoacetat, Butyrolacton, Isophoron, Triethylphosphat, Carbitolacetat, Propylencarbonat und Glycerintriacetat ausgewählt ist.

7. Zusammensetzung nach einem der Ansprüche 1 bis 6, wobei:
- das elektroaktive fluorierte Terpolymer eine Molmasse Mw von 200.000 bis 1.500.000, vorzugsweise von 250.000 bis 1.000.000, besonders bevorzugt von 300.000 bis 700.000, aufweist; und/oder
- das zweite Polymer eine Molmasse Mw von 500 bis 700.000, vorzugsweise von 2000 bis 100.000 und besonders bevorzugt von 5000 bis 20.000 aufweist,
die Molmasse Mw mittels Größenausschlusschromatographie bestimmt wird, wobei die Chromatographie mit den folgenden Parametern durchgeführt wird:
- Verwendung von 3 Säulen mit zunehmender Porosität;
- beim Elutionsmittel handelt es sich um Dimethylformamid;
- bei der stationären Phase handelt es sich um ein Styrol-DVB-Gel;
- die Detektion basiert auf einer Messung des Brechungsindex und
- die Kalibrierung erfolgt mit Polystyrol-Standards.

8. Zusammensetzung nach einem der Ansprüche 1 bis 7, die darüber hinaus ein fluoriertes, insbesondere ferroelektrisches, Copolymer umfasst, das vorzugsweise aus Copolymeren von Vinylidenfluorid und Trifluorethylen, Vinylidenfluorid und Chlortrifluorethylen, Vinylidenfluorid und Tetrafluorethylen und Vinylidenfluorid und Hexafluorpropylen ausgewählt ist.

9. Zusammensetzung nach einem der Ansprüche 1 bis 8, wobei das elektroaktive fluorierte Terpolymer ein relaxierendes Terpolymer ist.

10. Verfahren zur Herstellung einer Zusammensetzung nach einem der Ansprüche 1 bis 9, das einen Schritt des Vermischens des elektroaktiven fluorierten Terpolymers mit dem zweiten Polymer umfasst.

11. Herstellungsverfahren nach Anspruch 10, wobei das Vermischen in einem Lösungsmittel erfolgt, das vorzugsweise aus Tetrahydrofuran, Methylethylketon, Dimethylformamid, Dimethylacetamid, Tetramethylharnstoff, Dimethylsulfoxid, Trimethylphosphat, N-Methyl-2-pyrrolidon, Aceton, Methylisobutylketon, Glycolethern, Glycoletherestern, n-Butylacetat, Cyclohexanon, Diacetonalkohol, Diisobutylketon, Ethylacetoacetat, Butyrolacton, Isophoron, Triethylphosphat, Carbitolacetat, Propylencarbonat und Glycerintriacetat ausgewählt ist; indem vorzugsweise das elektroaktive fluorierte Terpolymer und dann das zweite Polymer im Lösungsmittel gelöst werden.

12. Vorrichtung, die ein Substrat und einen darauf angeordneten Film der Zusammensetzung nach einem der Ansprüche 1 bis 9 umfasst.

13. Vorrichtung nach Anspruch 12, die weiterhin auf beiden Seiten des Films Elektroden umfasst, wobei es sich bei der Vorrichtung vorzugsweise um einen Aktor handelt.

14. Verfahren zur Herstellung der Vorrichtung nach einem der Ansprüche 12 oder 13, das einen Schritt des Abscheidens des Films auf dem Substrat umfasst.

15. Verfahren zur Herstellung der Vorrichtung nach Anspruch 14, wobei der Schritt des Abscheidens ein Schritt des Auftragens oder Aufdruckens der Zusammensetzung auf das Substrat ist.

16. Verfahren zur Herstellung der Vorrichtung nach einem der Ansprüche 14 oder 15, das einen zusätzlichen Schritt des Abscheidens von Elektroden vorzugsweise durch das Aufdampfen oder Aufsprühen von Metall, Indium-Zinn-Oxid, einer Schicht eines leitenden Polymers, leitfähiger Druckfarbe auf Silberbasis, Silber-Nanodrähten oder Graphen umfasst.

## Claims

1. Composition comprising:
- at least one electroactive fluoroterpolymer, the electroactive fluoroterpolymer being a terpolymer of vinylidene fluoride, of trifluoroethylene and of a third monomer, the molar proportion of third monomer having a value of 2% to 15%, the third monomer being 1-chloro-1-fluoroethylene or chlorotrifluoroethylene, and
- at least one second polymer, being a polyester, compatible with the electroactive fluoroterpolymer and exhibiting a glass transition temperature lower than that of the electroactive fluoroterpolymer,
the glass transition temperature being measured by differential scanning calorimetry according to Standard ASTM E1356;
the word "compatible" meaning that the mixture of said at least one electroactive fluoroterpolymer with said at least one second polymer forms a homogeneous phase with a single glass transition temperature.

2. Composition according to Claim 1, in which the second polymer exhibits a glass transition temperature lower by at least 5°C, preferably by at least 10°C, or by at least 15°C, or by at least 20°C, than that of the electroactive fluoroterpolymer.

3. Composition according to either one of Claims 1 and 2, in which a glass transition temperature of the electroactive fluoroterpolymer has a value of -50°C to +10°C, preferably of -40°C to -10°C; and/or the glass transition temperature of the second polymer has a value of -100°C to -0°C, preferably of -100°C to -40°C.

4. Composition according to any one of Claims 1 to 3, in which the second polymer is chosen from polyadipates, polyglutarates and polysebacates.

5. Composition according to any one of Claims 1 to 4, in which the electroactive fluoroterpolymer and the second polymer are present in a ratio by weight of 50:50 to 99:1, preferably of 70:30 to 95:5 and more particularly preferably of 80:20 to 90:10.

6. Composition according to any one of Claims 1 to 5, comprising at least one solvent preferably chosen from tetrahydrofuran, methyl ethyl ketone, dimethylformamide, dimethylacetamide, tetramethylurea, dimethyl sulfoxide, trimethyl phosphate, N-methyl-2-pyrrolidone, acetone, methyl isobutyl ketone, glycol ethers, glycol ether esters, n-butyl acetate, cyclohexanone, diacetone alcohol, diisobutyl ketone, ethyl acetoacetate, butyrolactone, isophorone, triethyl phosphate, carbitol acetate, propylene carbonate and glyceryl triacetate.

7. Composition according to any one of Claims 1 to 6, in which:
- the electroactive fluoroterpolymer exhibits a molecular weight Mw of 200 000 to 1 500 000, preferably of 250 000 to 1 000 000 and more particularly of 300 000 to 700 000; and/or
- the second polymer exhibits a molecular weight Mw of 500 to 700 000, preferably of 2000 to 100 000 and more particularly of 5000 to 20 000,
the molecular weight Mw being determined by size exclusion chromatography, the chromatography being carried out with the following parameters:
- use of 3 columns of increasing porosity;
- the eluent is dimethylformamide;
- the stationary phase is a styrene-DVB gel;
- the detection is based on a measurement of the refractive index; and
- the calibration is carried out with polystyrene standards.

8. Composition according to any one of Claims 1 to 7, also comprising a fluorocopolymer, in particular a ferroelectric fluorocopolymer, preferably chosen from copolymers of vinylidene fluoride and of trifluoroethylene, of vinylidene fluoride and of chlorotrifluoroethylene, of vinylidene fluoride and of tetrafluoroethylene, and of vinylidene fluoride and of hexafluoropropylene.

9. Composition according to any of Claims 1 to 8, in which the electroactive fluoroterpolymer is a relaxor terpolymer.

10. Process for the manufacture of a composition according to any one of Claims 1 to 9, comprising a stage of mixing the electroactive fluoroterpolymer with the second polymer.

11. Manufacturing process according to Claim 10, in which the mixing is carried out in a solvent preferably chosen from tetrahydrofuran, methyl ethyl ketone, dimethylformamide, dimethylacetamide, tetramethylurea, dimethyl sulfoxide, trimethyl phosphate, N-methyl-2-pyrrolidone, acetone, methyl isobutyl ketone, glycol ethers, glycol ether esters, n-butyl acetate, cyclohexanone, diacetone alcohol, diisobutyl ketone, ethyl acetoacetate, butyrolactone, isophorone, triethyl phosphate, carbitol acetate, propylene carbonate and glyceryl triacetate; preferably by dissolving the electroactive fluoroterpolymer and then the second polymer in the solvent.

12. Device comprising a substrate and a film of the composition according to one of Claims 1 to 9 deposited on the substrate.

13. Device according to Claim 12, additionally comprising electrodes on either side of the film, said device preferably being an actuator.

14. Process for the manufacture of the device according to either one of Claims 12 and 13, comprising a stage of deposition of the film on the substrate.

15. Process for the manufacture of the device according to Claim 14, in which the stage of the deposition is a stage of coating or printing the composition on the substrate.

16. Process for the manufacture of the device according to either one of Claims 14 and 15, comprising an additional stage of deposition of electrodes, preferably by evaporation or sputtering of metal, indium tin oxide, a layer of conductive polymer, conductive ink based on silver, silver nanowires, or graphene.
